# EUROPÄISCHE PATENTSCHRIFT

(11) **EP 3 192 174 B1**
(45) Veröffentlichungstag und Bekanntmachung des Hinweises auf die Patenterteilung: **17.06.2026**
(21) Anmeldenummer: 15762988.2
(22) Anmeldetag: 11.09.2015
(51) Int. Cl.: H03K 17/96, G01L 1/14, G01L 1/16, G06F 3/041, G06F 3/01, G06F 3/0338, G06F 3/0346, G06F 3/0354, G06F 3/044, B25J 13/06

(54) **BEDIENEINHEIT**
OPERATING UNIT
UNITÉ DE COMMANDE

(30) Priorität: 11.09.2014 DE 102014218207
(43) Veröffentlichungstag der Anmeldung: 19.07.2017
(73) Patentinhaber: Fraunhofer-Gesellschaft zur Förderung der angewandten Forschung e.V., 80686 München (DE)
(72) Erfinder: ELKMANN, Norbert, 39104 Magdeburg (DE); FRITZSCHE, Markus, 39114 Magdeburg (DE); URBAHN, Christoph, 39108 Magdeburg (DE); MÜLLER, Veit, 39108 Magdeburg (DE)
(74) Vertreter: Pfenning, Meinig & Partner mbB
(86) Internationale Anmeldenummer: PCT/EP2015/070824
(87) Internationale Veröffentlichungsnummer: WO 2016/038187

(56) Entgegenhaltungen:
- EP-A2- 1 764 264
- EP-B1- 1 764 264
- WO-A1-2013/035725
- US-A1- 2006 197 750
- US-A1- 2013 169 519
- US-A1- 2014 224 040

## Beschreibung

Gegenstand der vorliegenden Anmeldung ist eine Bedieneinheit zur Bedienung einer Maschine, wobei die Bedieneinheit eine Haltefläche und eine mit der Maschine verbindbare Signalverarbeitungseinrichtung umfasst.

Bedieneinheiten zur Bedienung einer Maschine sind elementar zum Betreiben von Maschinen und Robotern. Hierbei kommen beispielsweise hand- oder fußbetätigten Zustimmeinrichtungen wichtige Bedeutungen zu, da diese die Sicherheit des Bedieners beim Betrieb von Maschinen und Robotern sicherstellen. Zustimmeinrichtungen werden beispielsweise als zwei- oder dreistufige Handschalter ausgeführt, oftmals auch als Zweihand-Steuerung, das heißt, dass die Maschine, der Roboter oder die Presse (nachfolgend alle unter dem Begriff Maschine zusammengefasst) sich erst dann bewegt (das heißt, in einen aktiven Betriebszustand versetzt wird), wenn beide Schalter gleichzeitig betätigt werden.

Im Stand der Technik sind verschiedene auch als Zustimmtaster bezeichnete Sicherheitsschalteinrichtungen als Bedieneinheiten für Maschinen bekannt. Diese Zustimmtaster sind in der Regel durch eine aufwändige Mechanik aus Federn und elektrischen Schaltkontakten gekennzeichnet, welche bestimmte unzulässige Schaltzustände ausschließen. Diese mechanischen Systeme weisen unter anderem den Nachteil auf, dass Abnutzungs- und Verschleißerscheinungen, Funkenbildung an den elektrischen Kontakten oder ein aufwändiger Aufbau zu Qualitätsproblemen führen. Weiterhin sind die Zustimmtaster teuer.

Desweiteren ist es nur eingeschränkt möglich, diese Zustimmtaster derart in bestehende Bedienvorrichtungen zu integrieren, dass dem Bediener stets eine ergonomische Betätigung ermöglicht wird. Zum Beispiel ist eine Kraftführung von Robotern im Handbetrieb mit herkömmlichen Zustimmeinrichtungen nicht ergonomisch möglich, da die Kraft zum Betätigen des Schalters aufgebracht wird und eine zusätzliche Kraftausübung bei dreistufigen Zustimmeinrichtungen eine "Panikfunktion" auslösen kann, das heißt, die Maschine wird in einen Not-AUS-Betriebszustand versetzt. Die
DE 100 23 199 A1 diskutiert einen Zustimmschalter, welcher mithilfe eines Kraft- und/oder Drucksensors das Wechseln zwischen verschiedenen Betriebsmodi erlaubt. Der Drucksensor wird mit einem Tastelement bedient und ist nicht durch eine Fläche, an welcher der Schalter gehalten wird, zugänglich.

Aus der DE 194 44 683 C3 ist ein Sicherheitsschaltsystem einer zweihandgesteuerten Schalteinrichtung bekannt, wobei auch hier ein Schaltelement zur Bedienung im Vordergrund steht.

In EP 1 764 264 A2 wird eine in ein Lenkrad integrierte Sensoreinrichtung samt Auswerteeinheit diskutiert, die es ermöglicht zwischen einem durch anhaltendes Drücken des Lenkrades initiiertem Bremssignal, und der Betätigung von im Fahrzeug angeordneten Entertainmentsystemen durch punktuelle Betätigungen der integrierten Sensoren zu unterscheiden.

US 2014/0224040 A1 diskutiert ebenfalls ein Lenkrad mit integrierten Sensoren, die es ermöglichen mittels einer Ortsauflösung festzustellen ob das Lenkrad aktuell von einer oder zwei Händen umfasst wird.

Aufgabe der vorliegenden Anmeldung ist es, Bedieneinheiten zur Verfügung zu stellen, welche eine vereinfachte und ergonomische Bedienung einer Maschine, beispielsweise eines Roboters, erlauben.

Die Aufgabe wird gelöst durch eine Bedieneinheit gemäß dem Anspruch 1. Weitere Ausführungsformen werden in den untergeordneten Ansprüchen sowie in den nachstehend aufgeführten Ausführungsbeispielen geschildert.

Gemäß Anspruch 1 umfasst die Bedieneinheit, zum Beispiel ein Zustimmschalter oder ein Handschalter, eine Haltefläche und eine mit einer Maschine verbindbare Signalverarbeitungseinrichtung. Die Haltefläche ist dergestalt, dass ein Bediener die Haltefläche beispielsweise mit der Hand oder beiden Händen umfassen kann. Alternativ kann die Haltefläche auch derart gestaltet sein, dass diese mittels eines Fußes, beider Füße oder einem anderen Körperteil bedient werden kann. Die Haltefläche ist ferner derart konfiguriert, dass es zu einer flächigen Berührung zwischen Haltefläche und Hand bzw. dem weiteren Körperteil kommen kann. So kann die Haltefläche beispielsweise eine Teilfläche eines Griffes, eines Lenkrades oder eines Joysticks sein. Die Haltefläche ist also eine beliebig geformte zwei- oder dreidimensionale Fläche.

Die Haltefläche kann gekrümmt sein und gegebenenfalls eine Vorderseite sowie eine Rückseite umfassen oder einen Teil der Vorderseite oder Rückseite bedecken, wobei die Haltefläche derart gestaltet sein kann, dass es zu einer flächigen Berührung auf einer Vorderseite der Haltefläche, auf einer Rückseite der Haltefläche oder zu einer gleichzeitigen flächigen Berührung sowohl auf der Vorderseite als auch auf der Rückseite der Haltefläche kommen kann. Die flächige Berührung wird hierbei vorzugsweise durch eine Hand oder durch einen oder mehrere Finger ausgeführt. Durch das Erfassen einer flächigen Berührung auf der Rückseite der Haltefläche kann sichergestellt werden, dass die Haltefläche durch die Hand umgriffen und nicht nur punktuell berührt wird.

Auch ist es möglich, dass die Haltefläche lediglich einen Teil einer Rückseite einer Bedieneinheit, beispielsweise eines Handbediengeräts zur Robotersteuerung, umfasst. Die flächige Berührung kann hierbei durch einen oder mehrere Finger erfolgen.

Die mit der Maschine verbindbare Signalverarbeitungseinrichtung dient der Verarbeitung eines Inputs durch ein erstes berührungssensitives Sensorsystem, welches ebenfalls Teil der Bedieneinheit ist. Mithilfe des Inputs des ersten berührungssensitiven Sensorsystems wird ein Output erzeugt, welcher beispielsweise als ein Steuersignal zur Steuerung bzw. zur Bedienung einer Maschine herangezogen wird. Hierbei kann die zu steuernde Maschinengröße das An- oder Ausschalten, die Bewegung, oder eine Geschwindigkeit einer Bewegung der Maschine oder eine Richtungsänderung einer Komponente der Maschine sein. Die Signalverarbeitungseinrichtung ist in einer Ausführungsform derart konfiguriert, dass die Maschine mittels eines ersten Steuersignals in einen ersten Betriebszustand und mittels eines zweiten Steuersignals in einen zweiten Betriebszustand versetzt werden kann. Als Betriebszustände können beispielsweise aktive Zustände der Maschine oder das Ausschalten der Maschine oder ein Not-AUS der Maschine definiert werden. In einem aktiven Betriebszustand kann zudem zwischen einer einmal initiierten Aktion und einem Betriebszustand unterschieden werden, in welchem eine Maschinengröße kontinuierlich verändert wird.

Alternativ kann das durch das erste berührungssensitive Sensorsystem generierte Signal in digitaler oder analoger Form durch die Signalverarbeitungseinrichtung verarbeitet und anschließend an die Maschine weitergeleitet werden. Die Signale werden dann in einer Steuereinheit der Maschine bei der Generierung von Steuersignalen herangezogen.

Somit ist es beispielsweise möglich, dass die Signalverarbeitungseinrichtung aus dem durch das berührungssensitive Sensorsystem generierten Signal bestimmt, ob eine flächige Berührung der Haltefläche vorliegt.

Die Haltefläche der Bedieneinheit umfasst das mindestens eine erste berührungssensitive Sensorsystem. Dies bedeutet, dass das Sensorsystem beispielsweise auf der Oberfläche der Haltefläche angeordnet wird. Als berührungssensitives Sensorsystem kann beispielsweise ein Taktilsensor verwendet werden, welcher einen elektrisch leitenden Schaumstoff, elektrisch leitendes Textil oder eine elektrisch leitende Folie umfasst, bei welcher aufgrund einer Veränderung des Volumenwiderstands oder des Durchgangswiderstands ein Signal ausgegeben wird, dessen Signalstärke von einer auf dem Sensorsystem aufgebrachten Kraft und/ oder Druck abhängig ist. Dabei kann in einigen Ausführungsformen das erste berührungssensitive Sensorsystem derart konfiguriert sein, dass die Signalstärke sich kontinuierlich verändert, wenn die Kraft und/ oder der Druck kontinuierlich verändert wird.

Alternativ können zur Realisierung des berührungssensitiven Sensorsystems auch andere Messprinzipien (z.B. kapazitiv, optisch, piezoelektrisch, induktiv, thermisch etc.) genutzt werden, um die auf die Haltefläche einwirkenden Kräfte/Drücke vorzugsweise quantitativ zu erfassen. Da die Haltefläche das mindestens eine erste berührungssensitive Sensorsystem umfasst, kann bereits bei einer Berührung der Haltefläche die auf die Haltefläche einwirkende Kraft durch das vom berührungssensitiven Sensorsystem ausgegebene Signal erfasst und ausgewertet werden. Das Signal des Sensorsystems wird dabei an die Signalverarbeitungseinrichtung übermittelt und bildet den Input bzw. den einen Eingang für die Signalverarbeitungseinrichtung. Da das erste berührungssensitive Sensorsystem derart konfiguriert ist, dass eine Kraft durch die Signalstärke abbildbar ist, kann die Kraft nicht nur qualitativ, sondern auch quantitativ zur Steuerung der Maschine herangezogen werden. Dabei können beispielsweise unterschiedliche Kräfte zu unterschiedlichen Steuersignalen führen, das heißt, beim Überschreiten einer ersten, zweiten oder dritten Kraftschwelle bzw. einer dazu korrespondierenden Signalstärke kann die Maschine jeweils ein Steuersignal erhalten, um in einen anderen Betriebszustand überführt zu werden. Der Signalverarbeitungseinrichtung kommt hierbei die Generierung des Steuersignals bzw. eines Signals für eine Steuereinheit der Maschine zu, wobei die Schaltlogik der Signalverarbeitungseinrichtung derart konfiguriert ist, dass das Signal des Sensorsystems eine für die Steuereinheit der Maschine verarbeitbare Information bereitstellt. Da die Haltefläche das mindestens eine berührungssensitive Sensorsystem umfasst, kann die Formgebung des berührungssensitiven Sensorsystems exakt an die beliebig geformte Haltefläche angepasst werden. So kann beispielsweise das berührungssensitive Sensorsystem derart gestaltet sein, dass es einem geometrischen Verlauf der Haltefläche folgt. Aufgrund der Flächigkeit des Sensorsystems auf der Haltefläche kann die Bedieneinheit an einer Vielzahl von Punkten berührt werden und die Bedieneinheit muss nicht länger lediglich an einem bestimmten Tastschalter bedient werden. Da das erste berührungssensitive Sensorsystem sich flächig über die Haltefläche erstreckt, kann das an einem beliebigen Ort des berührungssensitiven Sensorsystems erfasste Signal zur Steuerung der Maschine herangezogen werden.

Die Haltefläche kann hierbei derart gestaltet sein, dass sie im Bereich des berührungssensitiven Sensorsystems geschlossen ist, so dass das berührungssensitive Sensorsystem in die Haltefläche integriert ist oder von dieser ummantelt ist und somit die Haltefläche im Bereich des Sensorsystems glatt ist und somit beispielsweise nicht durch die Form der Haltefläche optisch erkennbar ist, wo genau auf, in oder unter der Haltefläche sich das berührungssensitive Sensorsystem erstreckt.

Alternativ ist es auch möglich, die Sensorzellen des Sensorsystems optisch zu kennzeichnen um beispielsweise die Bedienung zu vereinfachen.

Hierbei ist es vorteilhaft, wenn das berührungssensitive Sensorsystem als flächiges Sensorsystem derart konfiguriert ist, dass eine Berührung an mehr als einem Punkt der Haltefläche erfassbar ist. Dadurch, dass die Berührung an mehr als einem Punkt der Haltefläche erfassbar ist, kann beispielsweise sichergestellt werden, dass nicht lediglich ein Teil einer Hand oder eines Fußes auf der Haltefläche anliegt, sondern dass die Hand, der Fuß oder ein beliebiges anderes Körperteil mit dem berührungssensitiven Sensorsystem flächig in Berührung steht. Hierdurch kann sichergestellt werden, dass die Maschine beispielsweise erst dann in einen aktiven Betriebszustand versetzt wird, wenn an mehr als einem Punkt eine Berührung des berührungssensitiven Sensorsystems bzw. der Haltefläche erfolgt.

In einer Ausführungsform ist das flächige Sensorsystem derart konfiguriert, dass dieses sich über eine Fläche der Haltefläche von mindestens 1 cm2, vorzugsweise mehr als 5 cm2 bzw. der Fläche des Körperteils (i. d. R. einer Hand), besonders bevorzugt mehr als 10 cm2 oder 20 cm2 erstreckt. Dass sich das berührungssensitive Sensorsystem über eine Fläche der Haltefläche erstreckt, kann beispielsweise bedeuten, dass das Sensorsystem eine Vielzahl von Sensorzellen oder eine Vielzahl von Sensoren erfasst, welche, jede für sich genommen, nur eine geringe Fläche aufweisen, diese "Sensorpunkte" jedoch voneinander beabstandet über eine größere Fläche der Haltefläche verteilt sind. Dies bedeutet, dass die Summe der Fläche der einzelnen Sensoren bzw. Sensorzellen des ersten berührungssensitiven Sensorsystems kleiner als die Fläche der Haltefläche sein kann, über welche sich das Sensorsystem erstreckt, das Sensorsystem sich jedoch über eine größere Fläche erstreckt.

Beispielsweise kann das berührungssensitive Sensorsystem sich derart über die Haltefläche erstrecken, dass an jedem Punkt einer zusammenhängenden Fläche von mehr als 1cm² oder 2cm², bevorzugt von mehr als 5cm², besonders bevorzugt von mehr als 10 cm² eine Berührung oberhalb einer gegebenen Kraftschwelle an jedem Punkt der zusammenhängenden Fläche erfasst wird.

Vorzugsweise erstreckt sich das berührungssensitive Sensorsystem hierbei über zumindest einen Teil der Haltefläche, der bei einer bestimmungsgemäßen Benutzung der Bedieneinheit flächig, beispielsweise durch eine Hand, einen Fuß oder ein anderes Körperteil des Benutzers, berührt wird, wobei eine Berührungsfläche zwischen dem anliegenden Körperteil und der Haltefläche sich vorzugsweise über mindestens 1cm² oder 2cm², bevorzugt 5cm², besonders bevorzugt über mindestens 10 cm² oder 20cm² erstreckt. Die Berührungsfläche kann hierbei zusammenhängend sein oder sie kann aus mehreren Teilflächen bestehen, wobei bevorzugt mindestens eine der Teilflächen der Berührungsfläche sich über eine Fläche von mindestens 1cm², 2cm ² oder 5cm², besonders bevorzugt mindestens 10cm² oder 20 cm² erstreckt.

In einer weiteren Ausführungsform kann das flächige Sensorsystem eine durch eine aufgebrachte Kraft das mindestens eine ausgegebene Signal generierende Fläche von mindestens 1cm², 2 cm² oder 5 cm², vorzugsweise mindestens 10 cm² oder 20 cm² aufweisen. Hierdurch wird die Fläche des Sensorsystems, bzw. die Summe der Flächen der Vielzahl von Sensorzellen bzw. der Vielzahl von Sensoren des Sensorsystems (also die reine Sensorfläche ohne die Abstände zwischen einzelnen Sensorzellen zu berücksichtigen) definiert. So kann in einigen Ausführungsbeispielen vorgesehen sein, dass das erste berührungssensitive Sensorsystem eine Gesamtfläche von mehr als 10 cm² entlang einer korrespondierenden Teilfläche der Haltefläche von 10 cm² aufweist. Unabhängig davon, an welchem Punkt eine Berührung des berührungssensitiven Sensorsystems erfolgt, kann eine Kraft, welche auf das berührungssensitive Sensorsystem erfolgt ist, zum Erzeugen eines Steuersignals verwendet werden.

Weiterhin ist es möglich, dass die Haltefläche, Berührungsfläche und/oder Fläche des Sensorsystems jeweils maximal 1 m², vorzugsweise maximal 200 cm², besonders bevorzugt maximal 100 cm² betragen.

In einer weiteren Ausführungsform kann das flächige Sensorsystem aus einer Vielzahl kleiner Sensorzellen bestehen, wobei jede der Sensorzellen kleiner als 1cm ² ist, vorzugsweise zwischen 1mm² und 5mm².

Weiterhin kann das Sensorsystem mehr als einen Sensor oder mehr als eine Sensorzelle umfassen, wobei jeder Sensor bzw. jede Sensorzelle derart konfiguriert ist, dass er/sie ein eigenes kraftabhängiges Signal ausgeben kann. In dieser Ausführungsform kann beispielsweise festgestellt werden, ob die auf den zwei verschiedenen Sensorzellen jeweils aufgebrachte Kraft darauf schließen lässt, dass eine Hand die Bedieneinheit umfasst. Wird beispielsweise lediglich eine Berührung auf einer Sensorzelle, nicht jedoch auf einer benachbarten Sensorzelle erfasst, wird die Maschine nicht in den aktiven Betriebszustand versetzt, da in der Signalverarbeitungseinrichtung abgelegte maschinenlesbarer Instruktionen die Signale verarbeiten und zum Ergebnis kommen, dass keine vollflächige Berührung der Hand vorliegt.

Hierbei kann die Signalverarbeitungseinrichtung beispielsweise konfiguriert sein zum Bestimmen, anhand der erfassten Signale der einzelnen Sensorzellen des berührungssensitiven Sensorsystems, ob eine flächige Berührung vorliegt.

In zahlreichen Ausführungsformen ist das erste berührungssensitive Sensorsystem ortsauflösend, das heißt, eine jeweils an verschiedenen Orten des berührungssensitiven Sensorsystems aufgebrachte Kraft kann den verschiedenen Sensorzellen und damit den Sensororten zugeordnet werden. Hierzu kann vorgesehen sein, eine Vielzahl von getrennt ansteuerbaren flächig verteilten Sensoren auf der Haltefläche zu anzuordnen und die einzelnen Signale der Sensoren, welche jeweils kraftabhängig sind, an die Signalverarbeitungseinrichtung zu übermitteln und gesammelt auszuwerten. Durch die Ortsauflösung kann beispielsweise erfasst werden, dass nicht nur eine punktuelle Berührung, sondern eine flächige Berührung vorliegt. Die Anzahl der zu verwendenden Sensorzellen hängt dabei von der zu erreichenden Steuerungseigenschaft durch die Bedieneinheit ab. Soll beispielsweise sichergestellt werden, dass ein Griff voll umschlossen wird, um die Maschine in einen aktiven Betriebszustand zu überführen, kann beispielsweise vorgesehen sein, zwei Sensorzellen an einer Vorder- und Rückseite der Haltefläche vorzusehen, wobei die Bedieneinheit die Maschine lediglich dann in den aktiven Betriebszustand zu versetzen vermag, wenn beide Sensoren eine Kraft oberhalb einer ersten Schwelle erfassen. Alternativ ist es auch möglich eine Bedieneinheit, beispielsweise ein Handbediengerät zur Robotersteuerung, lediglich auf der Rückseite mit einer oder mehreren Sensorzellen zu versehen, die dann eine kleinflächige Berührung, z.B. durch einen oder mehrere Finger des Benutzers erfassen können. Eine derartig gestaltete Bedieneinheit kann derart konfiguriert sein, dass die durch sie gesteuerte Maschine nur dann in einen aktiven Betriebszustand versetzt wird, die mindestens eine Sensorzelle eine Kraft oberhalb einer ersten Schwelle erfasst. Die erste Kraftschwelle kann hierbei gegebenenfalls niedrig gewählt sein, um einem Verkrampfen des Benutzers vorzubeugen.

Zur Ortsauflösung der Signale des berührungssensitiven Sensorsystems ist es weiterhin möglich, die gemessenen Werte, Kräfte oder Drücke durch eine zweidimensionale Wertematrix darzustellen.

In der beanspruchten Ausführungsform generiert die Signalverarbeitungseinrichtung ein erstes Steuersignal durch ein beim Überschreiten einer ersten Kraft generiertes Signal, und ein zweites Steuersignal durch ein beim Überschreiten einer zweiten Kraft generiertes Signal, wobei die zweite Kraft größer ist als die erste Kraft. In diesem Fall kann beispielsweise beim Überschreiten der ersten Kraft die Maschine in einen aktiven Betriebszustand versetzt werden, und beim Überschreiten der zweiten Kraft die Maschine in einen Not-AUS-Zustand versetzt werden. So kann in Abhängigkeit von der auf die Bedieneinheit aufgebrachten Kraft eine Bedienung einer Maschine initiiert werden.

In weiteren Ausführungsbeispielen kann beispielsweise beim Überschreiten einer ersten Kraft die Maschine in einen aktiven Betriebszustand versetzt werden, und bei einem Unterschreiten der ersten Kraft die Maschine wieder in den AUS-Zustand versetzt werden. Liegt eine Kraft oberhalb der ersten Kraft an, kann das zur Kraft korrespondierende Signal dazu verwendet werden, die Geschwindigkeit der Maschine zu steuern. So kann beispielsweise bei einer Kraft größer als der ersten Kraft das Zunehmen der Kraft zur Steigerung der Geschwindigkeit der Maschine verwendet werden. Übersteigt die Kraft jedoch eine zweite Kraft, wird die Geschwindigkeit der Maschine auf einem konstanten Niveau gehalten. Überschreitet die Kraft nun eine dritte Kraftschwelle, wird die Maschine in einen Not-AUS-Zustand versetzt. Das heißt, in einigen Ausführungsformen ist vorgesehen, dass durch die auf das erste Sensorsystem aufgebrachte Kraft ein Steuersignal generierbar ist, welches eine Steuergröße der Maschine in Abhängigkeit von der aufgebrachten Kraft vorzugweise kontinuierlich verändert. Unter dieser Maschinengröße kann beispielsweise eine Geschwindigkeit der Maschine, eine lineare oder rotierende Bewegung oder Ähnliches initiiert werden.

In einer weiteren Ausführungsform umfasst die Bedieneinheit bzw. das erste berührungssensitive Sensorsystem keine mechanischen Schalt- und/oder Steuerelemente. Das heißt, zur Generierung der Steuersignale werden lediglich Signale des berührungssensitiven flächigen Sensorsystems verwendet. Die Signale des berührungssensitiven Sensorsystems können hierbei beispielsweise kapazitive Signale, oder Signale die einem elektrischen Widerstand entsprechen, sein.

In der beanspruchten Ausführungsform ist das mindestens eine erste berührungssensitive Sensorsystem derart konfiguriert, dass mindestens zwei verschiedenen Orten zugeordnete, durch das Sensorsystem ausgegebene Signale ortsauflösbar sind und die ausgegebenen Signale an die Signalverarbeitungseinrichtung übermittelt werden und zumindest das erste Steuersignal anhand der zwei, den verschiedenen Orten zugeordneten, Signalen initiiert wird. Bei dieser Art der Ortsauflösung kann beispielsweise vorgesehen sein, dass auch eine Zweihand-Steuerung bzw. Zweihand-Aktivierung einer Maschine erkannt wird. Die Signalverarbeitungseinrichtung kann beispielsweise derart konfiguriert sein, dass diese erkennt, dass zwei flächige Berührungen an unterschiedlichen Teilflächen des ersten berührungssensitiven Sensorsystems anliegen. Dies kann dahingehend gedeutet werden, dass zwei Hände die Haltefläche beispielsweise umschließen. Dabei kann die Signalverarbeitungseinrichtung derart konfiguriert sein, dass diese zunächst erfasst, dass an mehr als zwei Orten eine Berührung erfolgt und anschließend optional ermittelt, ob die Berührung an zwei verschiedenen, voneinander beabstandeten Orten jeweils eine flächige Berührung an den zwei verschiedenen Orten darstellt. Hierdurch kann ausgeschlossen werden, dass lediglich eine punktuelle Berührung an den zwei Orten vorliegt.

In einer weiteren Ausführungsform ist die Bedieneinheit derart ausgebildet, dass diese einen biegesteifen Grundkörper umfasst, und die Haltefläche durch zumindest einen Teilabschnitt des biegesteifen Grundkörpers gegeben ist. Als biegesteifen Grundkörper können beispielsweise Griffe, Lenkräder, Joysticks oder Ähnliches aus Metallen, Plastik oder anderen Kunststoffen verwendet werden. Der Grundkörper kann beispielsweise einen hohlen Querschnitt aufweisen und einen in seinem Querschnitt rund, rechteckig, oval oder eine andere an die Verwendung der Bedieneinheit angepasste Geometrie aufweisen.

In weiteren Ausführungsformen kann die Bedieneinheit jedoch auch ein biegeschlaffes Element umfassen, wiebeispielsweise ein Seil, wobei eine Teiloberfläche des Seiles die Haltefläche bildet und auf welcher das erste berührungssensitive Sensorsystem angeordnet ist.

In einer weiteren Ausführungsform umfasst die Bedieneinheit Ausgabeelemente, welche zur Ausgabe eines Betriebszustands der Maschine durch ein visuelles, auditorisches oder vibrotaktiles Ausgabesignal ausgebildet sind. Als Ausgabeelement kann beispielsweise ein Display oder Leuchtdiode dienen, welches den Betriebszustand anzeigt. Das Display oder die Leuchtdiode kann dabei beispielsweise lediglich eine Leuchtinformation umfassen, zum Beispiel eine grüne Leuchtinformation für einen aktiven Betriebszustand und eine rote Leuchtinformation für einen ausgeschalteten Zustand einer Maschine, oder ein Textdisplay, welches weitere Informationen zum Betriebszustand ausgeben kann. Als auditorisches Ausgabesignal kann beispielsweise ein Signalton oder eine Sprachausgabe durch einen Lautsprecher erfolgen, um dem Bediener den Betriebszustand mitzuteilen. Weiterhin kann beispielsweise durch einen Aktor im Bereich der Haltefläche ein Vibrationssignal an den Bediener übermittelt werden, durch welches der Bediener erkennt, in welchem Betriebszustand sich die Maschine nunmehr befindet. Die Signale, welche zur Initiierung der Ausgabe des Betriebszustandes auf dem entsprechenden Ausgabeelement nötig sind, können beispielsweise durch die Signalverarbeitungseinrichtung bereitgestellt werden.

In einem weiteren Ausführungsbeispiel umfasst die Bedieneinheit ein zweites berührungssensitives Sensorsystem, wobei ein vom zweiten berührungssensitiven Sensorsystem ausgegebenes Signal unabhängig von einem durch das erste berührungssensitive Sensorsystem ausgegebenes Signal ist. So können beispielsweise zwei, räumlich voneinander getrennte Teilflächen der Halteflächen mit jeweils einem eigenen berührungssensitiven Sensorsystem ausgestattet werden. Dabei kann das zweite berührungssensitive System beispielsweise ein druckempfindliches Sensorsystem aber auch ein piezoresistiven, kapazitives, induktives oder thermisches Sensorsystem sein.

In einer weiteren Ausführungsform sind das erste und das zweite berührungssensitive Sensorsystem zumindest abschnittsweise in Lagen übereinander auf der Haltefläche angeordnet, so dass sich im Querschnitt eine Reihenfolge von Haltefläche, zweites Sensorsystem und erstes Sensorsystem im Querschnitt ergibt. Ist beispielsweise das zweite berührungssensitive Sensorsystem ein kapazitives Sensorsystem, so kann dieses Sensorsystem dazu verwendet werden, um eine erste Berührung der Haltefläche zu erkennen. Hierdurch kann beispielsweise qualitativ festgestellt werden, ob eine Berührung vorliegt. Mit einem ortsauflösenden, kapazitiven Sensorsystem kann zudem festgestellt werden, ob eine flächige Berührung im Bereich des kapazitiven Sensorsystems vorliegt. Ist dies der Fall, beispielsweise im Rahmen einer Einhand- oder Zweihand-Berührung, kann diese Information zur Initiierung eines aktiven Betriebszustands verwandt werden. Ist das erste Sensorsystem ein kraftabhängiges Sensorsystem, kann dieses, nachdem das zweite kapazitive Sensorsystem die Maschine in den aktiven Betriebszustand versetzt hat, zur Steuerung einer Maschinengröße, wie beispielsweise der (Betriebs)-Geschwindigkeit einer Maschine, mittels der aufgebrachten Kraft auf das erste Sensorsystem verwendet werden. In diesem Fall ist also das zweite berührungssensitive Sensorsystem mit einem Steuersignal korreliert, welches einen aktiven Betriebszustand der Maschine initiiert und das erste druckempfindliche Sensorsystem mit einem weiteren Betriebszustand korreliert, welcher eine direkte Geschwindigkeits- oder Bewegungssteuerung der Maschine ermöglicht. Weiterhin kann beim Überschreiten einer bestimmten Kraft auch ein Not-AUS der Maschine initiiert werden. In einer weiteren Ausführungsform kann das System zweikanalig ausgeführt sein. Dies bedeutet, dass bei zwei, sich zumindest teilweise in Lagen überlappend angeordneten Sensorsysteme beide Sensorsysteme zur Steuersignalerzeugung ein bestimmtes Signal generieren müssen. Ein derartiges zweikanaliges System kann eine Maschine nur dann in einen bestimmten Betriebszustand schalten, wenn beide Sensorsysteme ein Signal erzeugen. Ist eines der beiden Sensorsystem defekt oder ein durch eines der beiden Sensorsysteme generierte Signal außerhalb eines vorbestimmten Intervall (beispielsweise zu hohe oder niedrige Kraft oder zu niedrige oder hohe Temperatur oder Ähnliches) wird der bestimmte Betriebszustand nicht initiiert.

Weitere Ausführungsformen ergeben sich aus den nachfolgenden Ausführungsbeispielen. Hierbei sei erwähnt, dass die einzelnen Ausführungsbeispiele jeweils eine Vielzahl von Merkmalen umfassen können. Einzelne in dem Ausführungsbeispiel beschriebene Merkmale können jedoch auch in anderen Bedieneinheiten zum Einsatz kommen.

Es zeigen:
- FIG. 1: eine erste Ausführungsform eines Systems mit einer Bedieneinheit, einer Signalverarbeitungseinrichtung und einer Maschine;
- FIG. 2: ein weiteres Ausführungsbeispiel einer Bedieneinheit;
- FIG. 3a bis 3c: Illustration der Zusammenhänge zwischen Kraft, Signalstärke und Ortsauflösung;
- FIG. 4a bis 4c: weiteres Ausführungsbeispiel einer Bedieneinheit;
- FIG. 5a und 5b: weiteres Ausführungsbeispiel einer Bedieneinheit;
- FIG. 6: Querschnitt eines weiteren Ausführungsbeispiels einer Bedieneinheit;
- FIG. 7: ein Ausführungsbeispiel einer Signalverarbeitungseinheit;
- FIG. 8: ein Ausführungsbeispiel einer weiteren Zustimmeinheit;
- FIG. 9: ein Ausführungsbeispiel einer zweihändigen Zustimmeinheit; und
- FIG. 10: ein weiteres Ausführungsbeispiel einer ringförmigen Zustimmeinheit.

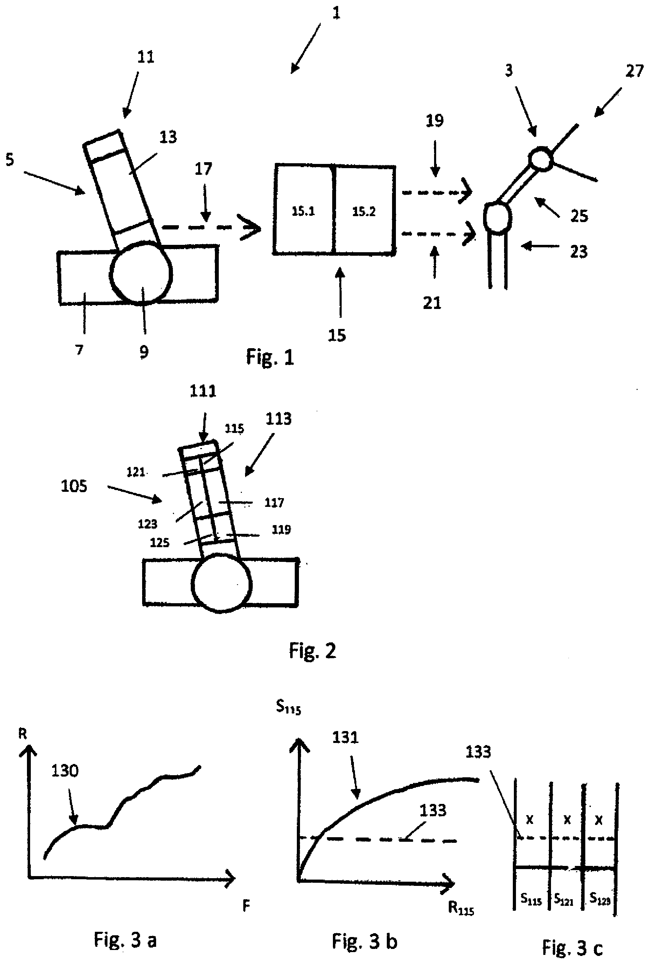

Anhand der FIG. 1 soll ein Ausführungsbeispiel einer Bedieneinheit erläutert werden. Die Bedieneinheit 1 ist zur Bedienung der Maschine 3 ausgebildet. Die Maschine 3 kann hierbei beispielsweise ein Roboter, eine Presse, eine Walze oder eine andere Maschine sein. Die Bedieneinheit 1 umfasst unter anderem einen Joystick 5, welcher eine Basis 7 und ein Gelenk 9 aufweist, auf welchem ein biegesteifes Rohr 11 beweglich angeordnet ist. Das biegesteife Rohr 11 besitzt einen runden Querschnitt und ist an seiner Oberfläche, welche nachfolgend als Haltefläche bezeichnet wird, mit einem Taktilsensor 13 belegt. Der Taktilsensor 13 folgt dabei der Geometrie des biegesteifen Rohres 11. Obgleich in dem vorliegenden Ausführungsbeispiel das biegesteife Rohr 11 einen runden Querschnitt aufweist, kann in anderen Ausführungsbeispielen die Kontur des Joysticks beispielsweise an Finger oder andere anatomische Besonderheiten einer menschlichen Hand angepasst sein. Der Taktilsensor liegt dabei flächig, und in manchen Ausführungsbeispielen bündig, am biegesteifen Rohr 11 an. Der Taktilsensor 13 umfasst eine einzige Sensorzelle, welche derart ausgebildet ist, dass eine auf die Sensorzelle aufgebrachte Kraft ein Signal erzeugt, dessen Signalstärke von der aufgebrachten Kraft abhängig ist. So kann die Signalstärke beispielsweise eine Proportionalität zur aufgebrachten Kraft aufweisen. Der Taktilsensor kann beispielsweise ein in der Druckschrift US 8,276,467 beschriebener Taktilsensor sein. Ein weiterer beispielhafter Taktilsensor wird beispielsweise in der Druckschrift WO 2001/042754 A1 beschrieben.

Die von dem Taktilsensor ausgehenden bzw. generierten Signale werden in einer Signalverarbeitungseinrichtung 15 verarbeitet. Dabei kann die Bedieneinheit über eine Verbindung 17 mit der Signalverarbeitungseinheit 15 verbunden sein. Die Verbindung kann beispielsweise drahtbasiert oder funkbasiert erfolgen.

Die Signalverarbeitungseinrichtung empfängt als Eingangssignal das durch den Taktilsensor im Falle einer aufgebrachten Kraft generierte Signal. In der Eingangsstufe 15.1 wird dieses Signal beispielsweise in ein digitales Signal gewandelt und weiterverarbeitet. Die Signalverarbeitungseinrichtung erzeugt ein Ausgangssignal, welches beispielsweise durch die Maschine 3 verarbeitet werden kann. Hierbei kann in einigen Ausführungsbeispielen vorgesehen sein, dass die Signalverarbeitungseinrichtung derart konfiguriert ist, dass ein erstes Steuersignal 19 oder ein zweites Steuersignal 21 mittels einer Ausgangsstufe 15.2 an die Maschine gesendet wird, und mit entsprechenden Steuersignalen die Maschine in einen ersten bzw. zweiten Betriebszustand setzen können.

So kann beispielsweise im Falle einer auf den Sensor aufgebrachten Kraft, welche eine erste Schwelle überschreitet, ein erstes Steuersignal generiert werden, welches die Maschine 3 aktiviert. Wird bei der aufgebrachten Kraft beispielsweise eine zweite, höhere Kraftschwelle überschritten, kann beispielsweise ein Not-Stopp der Maschine initiiert werden.

In dem in der FIG. 1 dargestellten Beispiel weist die Maschine 3 bewegbare Teilsegmente 23 und 25 und an seiner Spitze einen Greifarm 27 auf. So kann beispielsweise eine Bewegung des biegesteifen Rohres 11 derart zur Steuerung der Maschine verwendet werden, dass die Teilsegmente 23 und 25 bewegt werden. Wenn an dem Taktilsensor 13 eine, oberhalb einer ersten Schwelle liegende Kraft anliegt, wird ein Signal erzeugt, welches in ein erstes Steuersignal umgesetzt wird und welches eine Aktivierung des Greifarms 27 bewirkt. So kann beispielsweise beim Überschreiten der ersten Kraftschwelle eine Annäherung der beiden Greifarme 27 erfolgen. Lässt die aufgebrachte Kraft wieder nach, kann beispielsweise ein weiteres Steuersignal erfolgen, welches ein Auseinanderbewegen der Greifarme zur Folge hat. Ist die auf dem Taktilsensor aufgebrachte Kraft jedoch größer als eine zweite Kraftschwelle, wird eine weitere Annäherung der Greifarme aneinander verhindert. Auf diese Weise kann beispielsweise zuverlässig vermieden werden, dass ein sich zwischen den Greifarmen befindliches Objekt zerdrückt wird.

In dem vorliegenden Beispiel muss der Bediener also nicht länger einen Tastschalter bedienen, um den Greifarm zu schließen, sondern kann anhand der aufgebrachten Kraft ein kontinuierliches Öffnen oder Schließen des Greifarms bewirken. Eine in der Signalverarbeitungseinrichtung 15 beschriebene Logik kann dergestalt sein, dass beim Überschreiten der ersten Kraftschwelle ein Steuersignal zur Aktivierung des Greifarms imitiert wird und nunmehr kontinuierlich ein Steuersignal in Abhängigkeit von der aufgebrachten Kraft an die Maschine übermittelt wird und anhand der aufgebrachten Kraft ein Öffnen oder Schließen des Greifarms bewirkt wird. Wird eine zweite Kraftschwelle überschritten, wird der Greifarm nicht weiter geschlossen, sondern in der letzten Position gehalten bzw. kann bei einer weiteren Kraftsteigerung durch die Signalverarbeitungseinrichtung in den ursprünglich geöffneten Zustand versetzt werden.

In dem vorhandenen Ausführungsbeispiel ist die Signalverarbeitungseinrichtung Teil der Steuereinheit der Maschine 3. In anderen Ausführungsformen kann die Bedieneinheit eine eigene Signalverarbeitungseinrichtung umfassen, welche mit einer Steuereinheit der Maschine gekoppelt wird. Dabei kann die Signalverarbeitungseinrichtung derart konfiguriert sein, dass diese lediglich ein für die Steuereinheit der Maschine verarbeitbares Signal zur Verfügung stellt, anhand dessen die Steuereinheit der Maschine ein Steuersignal generieren kann, welches die entsprechende Aktion der Maschine initiiert. In weiteren Ausführungsbeispielen kann die Signalverarbeitungseinrichtung auch derart ausgestaltet sein, dass diese direkt Steuersignale an eine Steuereinheit der Maschine überträgt.

Ein weiteres Ausführungsbeispiel einer Bedieneinheit ist in der Figur 2 dargestellt. Auch in diesem Beispiel ist die Bedieneinheit 105 ein Joystick. Neben der Basis, in welcher wiederum ein biegesteifes Element 111 angeordnet ist, ist ein Taktilsensor 113 vorhanden, welcher sich der Haltefläche des biegesteifen Elements 111 anschmiegt. In dem vorliegenden Ausführungsbeispiel umfasst der Taktilsensor 113 eine Vielzahl von Sensorzellen, welche exemplarisch als Sensorzellen 115, 117, 119, 121, 123, 125 dargestellt sind. Die Sensorzellen erzeugen jeweils unabhängig von einer benachbarten Sensorzelle ein kraftaufgelöstes Signal. Da die verschiedenen Sensorzellen einen Großteil der Haltefläche überdecken, kann mit dem exemplarischen Taktilsensor nicht nur die insgesamt auf das Sensorsystem wirkende Kraft aufgelöst werden, sondern auch bestimmt werden an welchen Sensorzellen eine Kraft anliegt und wie groß diese Kraft ist.

Mittels der ortsaufgelösten Krafterfassung kann festgestellt werden, ob auf den Taktilsensor 113 lediglich punktuell eine Kraft aufgebracht wird, oder ob die Kraft oder eine Kraft an einer Vielzahl von Sensorzellen erfassbar ist. Auf diese Weise kann ermittelt werden, ob ein Bediener der Maschine den Joystick auch mit der gesamten Hand umgreift und nicht lediglich den Joystick an einem einzelnen Punkt berührt. Die in diesem Ausführungsbeispiel nicht dargestellte Signalverarbeitungseinrichtung ist so konfiguriert, dass diese die einzelnen Signale der Sensorzellen auswertet und ermittelt, ob an einer Vielzahl von Sensorzellen eine Kraft erfasst werden kann. In diesem Fall, wird zudem eine Gesamtsumme der auf das Sensorsystem wirkenden Kräfte ermittelt und anhand dieser bestimmt, ob beispielsweise der Greifarm der Figur 1 aktiviert werden soll.

In der FIG. 2 ist erkennbar, dass sich beispielsweise die Sensorzellen 115 und 121 auf benachbarten Seiten (beispielsweise der Vorder- und Rückseite) des Joysticks gegenüber liegen. So kann die Signalverarbeitung eine Aktivierung des Greifarms beispielsweise dann initiieren, wenn an zwei sich gegenüberliegenden Sensorzellen ein Signal erfasst wird, da dies darauf deutet, dass die Hand die Haltefläche zumindest teilweise (beispielsweise mehr als 150° oder 180° des Grundkörpers im Querschnitt) umschließt.

In den FIG. 3a bis 3c wird näher auf die Kraftabhängigkeit der Signale eingegangen. In der Figur 3a ist auf der Ordinate die auf eine Sensorzelle (beispielsweise die Sensorzelle 115) wirkende Kraft aufgetragen. Die Messgröße der Sensorzelle (z.b. der Durchgangswiderstand) kann dabei proportional zur aufgebrachten Kraft steigen oder fallen, wobei die Abhängigkeit wie dargestellt nicht linear sein muss.

In der FIG. 3b ist illustriert wie der Durchgangswiderstand mit dem an dieser Sensorzelle generierten Signal zusammenhängt. Die Signalstärke 131 ist abhängig von der am Sensor 115 anliegenden Kraft. Überschreitet die Signalstärke 130 nun eine erste Kraftschwelle 133, so ermittelt die Signalverarbeitungseinrichtung, dass eine Berührung an der Sensorzelle 115 anliegt. Liegt eine Kraft höher einer ersten Schwelle an mehr als einer Sensorzelle an (zum Beispiel anhand der FIG. 3c gezeigt, eine, jeweils an den Sensorzellen 115, 121 und 123 anliegende Kraft), ermittelt die Signalverarbeitungseinrichtung, dass drei benachbarte, jedoch unter anderem auf verschiedenen Seiten des biegesteifen Elements liegende Sensorzellen mit einer Kraft beaufschlagt sind und somit davon auszugehen ist, dass ein teilweises Umschließen des Sensors vorliegt.

In weiteren Ausführungsbeispielen kann die Signalverarbeitungseinrichtung derart ausgebildet sein, dass diese im Falle einer anliegenden konstanten Kraft ebenfalls ein Not-AUS-Signal generiert. Da beispielsweise die menschliche Hand nicht dauerhaft in der Lage ist eine sehr konstante Kraft auf den Taktilsensor aufzubringen, sondern diese Kraft gewissen Schwankungen unterworfen ist, kann anhand der geringen Schwankungen festgestellt werden, dass tatsächlich der Bediener eine aktive Steuerung der Bedieneinheit übernimmt. So kann verhindert werden, dass beispielsweise eine dauerhafte Aktivierung mittels einer Schelle nicht erkannt wird. Dies ist insbesondere in Ausführungsbeispielen vorteilhaft, in welchen die Bedieneinheit auch als Zustimmschalter verwendet wird.

In dem in der FIG. 2 gezeigten Ausführungsbeispiel weist das biegesteife Element 111 eine Oberfläche von ca 80 cm² auf (ungefähre Länge 10 cm, ungefährer Durchmesser 3 cm). Von dieser Oberfläche sind zumindest 60 cm² durch den Taktilsensor 113 belegt. In weiteren Ausführungsformen kann vorgesehen sein, dass die einzelnen Sensorzellen insgesamt kleiner sind, jedoch größere Abstände voneinander aufweisen, so dass das Sensorsystem insgesamt wiederum einen Großteil der Haltefläche überdeckt. So kann beispielsweise eine Sensorzelle lediglich eine Größe von wenigen Quadratmillimetern aufweisen. Sind jeweils benachbarte Sensorzellen beispielsweise jeweils 1,5 cm voneinander entfernt, kann wiederum aus der Vielzahl der verschiedenen Sensoren ermittelt werden, ob eine vollflächige Berührung einer Hand vorliegt. Nur in diesem Falle kann dem Beispiel der FIG. 1 folgend der Greifarm aktiviert werden.

Die in den FIG. 1 und 2 gezeigten Bedieneinheiten weisen Sensorsysteme ohne mechanische Tast- oder Schaltelemente auf. Die Krafterfassung wird hierbei lediglich durch eine Widerstandsänderung einer Folie oder eines Schaumstoffes bewirkt. In anderen Ausführungsbeispielen kann zumindest eine Ortsauflösung auch anhand eines kapazitiven Sensorsystems ermittelt werden. Für den Fall, das das kapazitive Sensorsystem lediglich eine Ortsauflösung besitzt bzw. eine Signalverarbeitungseinrichtung eine Ortsauflösung auswerten kann, kann zumindest ein flächiges Anliegen beispielsweise einer Hand gegenüber einer punktuellen Berührung unterschieden werden.

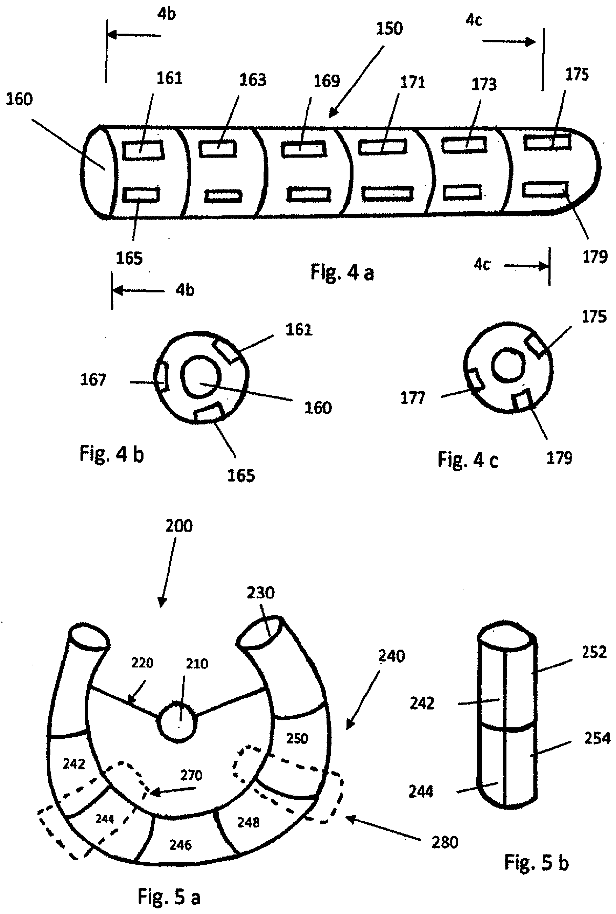

Anhand der FIG. 4a bis 4c soll eine weitere Ausführungsform einer Bedieneinheit illustriert werden. Die Bedieneinheit 150 umfasst einen biegesteifen Grundkörper 160, welcher mit einer Vielzahl von Sensorzellen belegt ist. Diese sind als rechteckige Elemente dargestellt und exemplarisch als Sensorzellen 161, 163, 165, 167, 169, 171, 173, 175, 177 und 179 dargestellt. Die Sensorzellen sind jeweils voneinander beabstandet und werden durch eine nicht eingezeichnete Verbindung an eine Signalverarbeitungseinrichtung gekoppelt. Die Bedieneinheit 150 kann beispielsweise als Zustimmschalter eingesetzt werden. In dem vorliegenden Beispiel handelt es sich um einen Zweihand-Zustimmschalter. Ein Zweihand-Zustimmschalter ist beispielsweise bei Maschinen wie Pressen oder Walzen erforderlich, um zu garantieren, dass der Bediener seine Hände nicht im Bereich der Presse oder Walze hält. Um sicherzustellen, dass beide Hände an dem Zustimmschalter anliegen, ist die Signalverarbeitungseinrichtung derart ausgebildet, dass diese ermittelt, ob beide Hände jeweils den Umfang des biegesteifen Körpers zumindest abschnittsweise, wie beispielsweise mehr als 180° oder mehr als 270°, umgreifen und ob beide Hände anliegen. Das Umgreifen der Hand kann beispielsweise dadurch ermittelt werden, dass eine oberhalb einer ersten Kraftschwelle liegende Kraft an den Sensoren 161, 163, 165 und 167 erfasst wird. Ein vollflächiges Umschließen einer weiteren Hand kann beispielsweise dadurch festgestellt werden, dass eine Kraft an den Sensoren 173, 175, 177 und 179 erfasst wird. Um sicherzustellen, dass beide Hände den Zustimmschalter umfassen, kann zudem vorgesehen sein, dass die Signalverarbeitungseinrichtung prüft, ob an den Zellen 169 und 171 eine Kraft anliegt. Die Signalverarbeitungseinrichtung kann derart konfiguriert sein, dass nur für den Fall, dass mindestens in Längsrichtung eine Sensorzellenreihe nicht mit einer Kraft beaufschlagt ist, eine Aktivierung der Maschine erfolgt.

Unter dem Begriff Umfassen eines Zustimmschalters durch eine Hand wir im Sinne der vorliegenden Anmeldung ein Umgreifen, Festhalten oder in die Hand nehmen verstanden, so dass die Hand beispielsweise eine Faust um die umgriffenen Gegenstand oder Zustimmschalter bildet. Dabei kann beispielsweise der Daumen des Benutzers die Fingerspitze eines anderen Fingers derselben Hand berühren oder zumindest in die Nähe dieser kommen. Der gehaltene Zustimmschalter befindet sich bei einem Umfassen durch eine Hand innerhalb der Hand und wird von dieser so gehalten, dass die Gefahr eines versehentlichen Abrutschens oder Abziehens der Hand vom Zustimmschalter gering ist. Der umfasste Zustimmschalter wird von der umfassenden Hand an mehreren Seiten berührt, so dass vorzugsweise mehr als 180° eines Umfangs eines Querschnitts des Zustimmschalters in Berührung mit der umfassenden Hand stehen.

Ein weiteres Ausführungsbeispiel einer Bedieneinheit ist beispielsweise in den FIG. 5a bis 5b dargestellt, Die Bedieneinheit 200 umfasst ein Steuerrad, welches an einer Achse 210 durch Streben 220 gehalten wird. Das Steuerrad umfasst einen biegesteifen Grundkörper 230, welcher in kreissegmentartiger Form geformt ist. Eine Teilfläche der Oberfläche des biegesteifen Elementes 230 ist mit einem berührungssensitiven Sensorsystem belegt. Das Sensorsystem liegt dabei flächig auf der Oberfläche des biegesteifen Elements 230 an und folgt der Kontur des biegesteifen Körpers. Das berührungssensitive Sensorsystem 240 umfasst eine Vielzahl von Sensorzellen 242, 244, 246, 248 und 250. Auf der nicht abgebildeten Rückseite befinden sich weitere Sensorzellen 252, 254, 256, 258 und 260. Dies ist beispielsweise in der Darstellung der FIG. 5b illustriert. In der FIG. 5a sind zudem beispielhaft zwei Handoberflächen 270 und 280 dargestellt, welche die Bedieneinheit 200 umschließen. Dabei ist die Signalverarbeitungseinrichtung derart konfiguriert, dass eine Aktivierung der Maschine nur dann möglich ist, wenn zum einen auf zwei gegenüberliegenden Sensoren wie dem Sensorpaar 242 und 252 bzw. 250 und 260 jeweils eine Krafterfasst wird, und zum anderen zwischen den mit Kraft beaufschlagten Sensoren 242 und 250 zumindest ein Sensor (im vorliegenden Fall der Sensor 246) vorhanden ist, welcher nicht mit einer Kraft beaufschlagt ist. Für diesen Fall wird durch die Signalverarbeitungseinrichtung erkannt, dass zwei Hände an der Bedieneinheit anliegen, und es wird ein Steuersignal an die Maschine übermittelt, dass die Maschine in den aktiven Modus überführt. Anschließend kann die Maschine beispielsweise anhand der aufgebrachten Kraft oder einer Rotation des Lenkrades gesteuert werden.

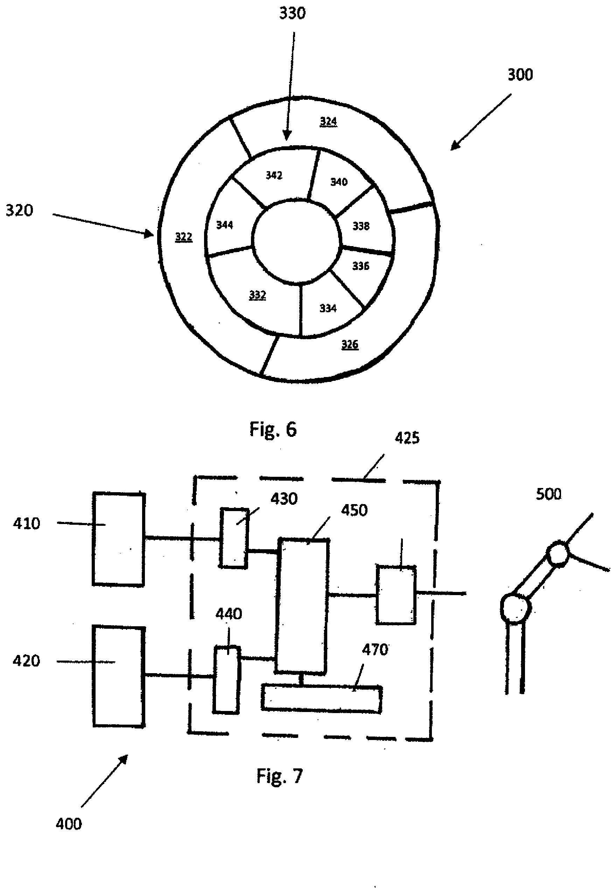

Anhand der FIG. 6 soll ein weiteres Beispiel einer Bedieneinheit im Querschnitt erläutert werden. Die Bedieneinheit 300 umfasst einen biegesteifen Grundkörper 310 wie beispielsweise den Endgriff eines Seils. Auf dem Grundkörper sind ein erstes berührungssensitives Sensorsystem 320 und ein zweites Sensorsystem 230 angeordnet. Bei dem ersten berührungssensitiven System handelt es sich um ein Sensorsystem, welches ein Sensorsignal abhängig von der aufgebrachten Kraft initiiert. Das zweite Sensorsystem ist ein kapazitives Sensorsystem und umfasst eine Vielzahl von Sensorzellen 332 bis 344. Dabei fungiert das zweite Sensorsystem zum Erfassen eines Näherungssignals und kann somit bestimmen, dass um den Umfang des Grundkörpers herum eine Näherung an den Grundkörper erfolgt ist. Anhand dieses Signals kann beispielsweise anschließend eine Aktivierung einer Maschine erfolgen. Alternativ kann das kapazitive Sensorsystem als außenliegendes Sensorsystem auf einem taktilen Sensorsystem angeordnet werden. In diesem Fall kann eine Aktivierung der Maschine derart erfolgen, dass das kapazitive Sensorsystem vorzugsweise flächig berührt werden muss. Die weitere auf das taktile Sensorsystem aufgebrachte Kraft kann entweder auch zur Aktivierung verwendet werden (etwa als zweikanaliges System) oder eine weitere Maschinengröße steuern. Das kapazitive Sensorsystem kann beispielsweise auf einer Umhüllung eines taktilen Sensorsystems angeordnet werden. Alternativ zum hier besprochenen kapazitiven oder taktilen Sensorsystem kann eines der Sensorsysteme auch durch ein thermisches Messsystem ersetzt werde, oder das thermische Messsystem kann als zusätzliches Messsystem eingesetzt werden. Zur weiteren Steuerung der Maschine kann beispielsweise die auf das erste Sensorsystem aufgebrachte Kraft herangezogen werden. Hierdurch kann, wie beispielsweise in dem Ausführungsbeispiel der FIG. 1 erläutert, ein Greifarm bewegt werden. Anstelle eines kapazitiven Sensorsystems kann auch ein Temperaturmesssystem eingesetzt werden. Hierbei kann beispielsweise ortsaufgelöst eine Temperatur erfasst werden, wobei aus einer Erhöhung der Temperatur um den gesamten Umfang des Grundkörpers herum auf eine Kontaktierung bzw. Berührung des selbigen durch eine Hand geschlossen werden kann.

Obgleich in den vorstehend aufgeführten Ausführungsbeispielen oftmals von einer Handberührung gesprochen wurde, kann die Bedieneinheit auch für einen Fuß oder eine Fußbedienung ausgebildet werden. Hier kann beispielsweise ermittelt werden, ob sowohl der Fußballen als auch die Verse die Bedieneinheit berühren. Ähnliches gilt für ein mit zwei Füßen gesteuertes System.

Ein weiteres Ausführungsbeispiel einer Signalverarbeitungseinrichtung wird anhand der FIG. 7 erläutert. Die Bedieneinheit 400 umfasst ein erstes Sensorsystem 410 und ein zweites Sensorsystem 420 beispielsweise wie in den vorhergehenden Ausführungsbeispielen beschrieben. Es kann sich hierbei beispielsweise um zwei Sensorsysteme, wie im Rahmen der FIG. 6 erläutert, oder um Zweihand-Zustimmschaltung, wie in den FIG. 4 und 5 erläutert, handeln. Das erste Sensorsystem 410 und das zweite Sensorsystem 420 sind mit einer Signalverarbeitungseinrichtung 425 gekoppelt. Hierzu verfügt die Signalverarbeitungseinrichtung über zwei Eingangsschnittstellen 430 und 440. In diesem können die von den Sensoren erfassten Signale vorverarbeitet, beispielsweise digitalisiert, werden. Die Signale werden anschließend einem Mikroprozessor 450 zugeführt, welcher die Signale verarbeitet. Der Mikroprozessor generiert ausgehend von den empfangenen Signalen ein Steuerungssignal für eine Maschine und übermittelt dieses Steuerungssignal an eine Ausgangsschnittstelle 460, welche mit einer Maschine 500 gekoppelt ist. Der Mikroprozessor 450 (CPU) ist mit einer Speichereinheit 470 verbunden, in welcher eine Vielzahl von Instruktionen abgelegt ist, um die eingehenden Signale des ersten und zweiten Sensorsystems 410 bzw. 420 zu verarbeiten und zu entsprechenden Steuersignalen zu verarbeiten. Als Speicher kommen beispielsweise Flash-speicher oder EEP-ROMs infrage. Auch andere aus dem Stand der Technik bekannte volatile oder nicht-volatile Speicher können Verwendung finden. Der Mikroprozessor kann beispielsweise derart konfiguriert sein, dass dieser jeweils einzeln die Signale der einzelnen Sensorzellen des ersten bzw. zweiten Sensorsystems empfängt. Allerdings kann auch die Eingangsschnittstelle 430 bzw. 440 bereits die empfangenen Signale vorverarbeiten und im Rahmen eines einzigen Signals, welches bereits vorverarbeitet ist, mit dem Mikroprozessor 450 kommunizieren. Der Mikroprozessor 450 kann auch derart konfiguriert sein, dass ein Steuersignal an eine Steuereinheit 500 übermittelt wird und diese Steuereinheit letztendlich das Steuersignal für die Maschine selbst generiert. Hierzu greift diese jedoch direkt auf die Steuersignale des Mikroprozessors 450 zurück. Die Bauelemente der Signalverarbeitungseinrichtung 425 sind beispielsweise auf einer Leiterplatte (PCB) angeordnet.

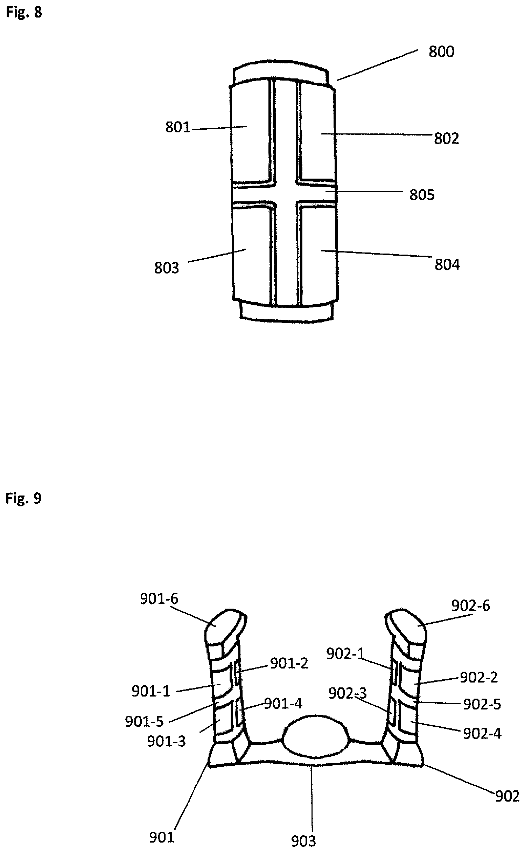

FIG. 8 zeigt eine taktile zylindrische Zustimmeinheit 800, die so dimensioniert wurde, dass sie vollständig von einer Hand umfasst werden kann. In die Oberfläche 805 des zylindrischen Zustimmschalters 800 sind vier voneinander unabhängige taktile Sensorzellen 801 - 804 integriert, welche durch Vertiefungen oder Markierungen in bzw. auf der Oberfläche markiert sind. Die Sensorzellen senden Daten über das Vorliegen und/oder die Stärke bzw. Kraft einer Berührung an einen in FIG. 8 nicht gezeigten Sensorcontroller . Der Sensorcontroller kann extern oder innerhalb des zylindrischen Zustimmschalters angeordnet sein. Der Sensorcontroller erzeugt nur dann ein Freigabesignal, wenn auf jede der Sensorzellen 801 - 804 eine Kraft oberhalb einer festgelegten ersten Kraftschwelle einwirkt, da dann von einem vollständigen Umfassen des zylindrischen Zustimmschalters 800 ausgegangen werden kann. Die Freigabe wird zurückgenommen wenn für eine der Sensorzellen 801 - 804 eine zweite festgelegte Kraftschwelle überschritten wird, womit eine Panikfunktion, beispielsweise bei Verkrampfen des Benutzers, realisiert ist. Auch kann die Freigabe zurückgenommen werden, wenn die erste Kraftschwelle für eine der Sensorzellen unterschritten wird. Das heißt, eine Freigabe wird nur erteilt, wenn sich die Messwerte aller vier Sensorzellen in dem durch die erste und zweite Kraftschwelle definierten Freigabefenster bewegen.

Es ist auch möglich, den zylindrischen Zustimmschalter aus FIG. 8 mit mehr oder weniger Sensorzellen zu versehen, auch können die festgelegten Kraftschwellen für die verschiedenen Sensorzellen unterschiedlich sein oder es kann, je nach Ausführungsform und Anzahl der Sensorzellen, eine Freigabe bereits erfolgen, wenn nur eine Teilmenge von Sensorzellen eine Kraft innerhalb des festgelegten Freigabefensters bewegen.

FIG. 9 zeigt eine zweihändige Zustimmeinheit, die aus zwei auf die Geometrie eines Zweihand-Joysticks angepasste taktile Zustimmeinheiten 901, 902 gemäß FIG. 8 umfasst. Die Ergonomie des dargestellten Joysticks ist durch die Integration taktiler Sensorflächen verbessert. Jede der beiden taktilen Zustimmeinheiten 901, 902 ist mit vier Sensorflächen 901-1bis 901-4 bzw. 902-1 bis 902-4 ausgestattet, die, wie in FIG. 8, in die Oberflächen 901-5, 902-5 der jeweiligen Zustimmeinheiten 901, 902 integriert sind. Der Abstand der über ein Mittelteil 903 verbundenen Zustimmeinheiten 901, 902 ist hierbei so gewählt, dass ein Benutzer die beiden Zustimmeinheiten 901, 902 bequem mit beiden Händen gleichzeitig umfassen kann. Hierbei werden die die Sensoreinheiten beinhaltende Oberflächen 901-5, 902-5 von den jeweiligen Händen des Benutzers umschlossen.

Weiterhin verfügen die beiden in FIG. 9 gezeigten Zustimmeinheiten 901, 902 über ein integriertes optisches Feedbacksystem. Hierbei leuchten sie oberen Enden 901-6, 902-6 der Zustimmeinheiten 901, 902, beispielsweise wenn sich die gemessene Kraft innerhalb des festgelegten Freigabefensters bewegt. Auch ist es möglich, dass die oberen Enden 901-6, 902-6 durch integrierte mehrfarbige LEDs in unterschiedlichen Farben leuchten, je nachdem ob die gemessene Kraft unterhalb, innerhalb oder oberhalb des Freigabefensters liegt.

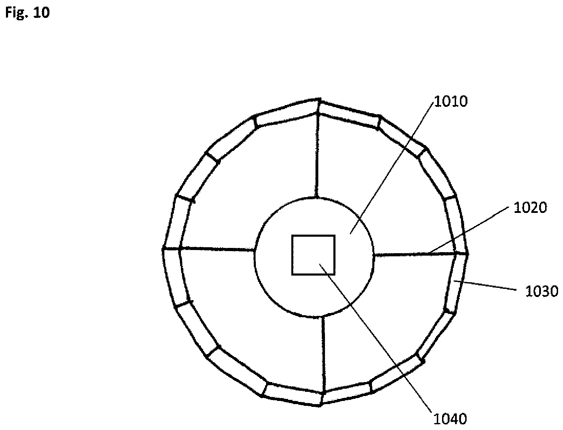

FIG. 10 zeigt eine ringförmige Zustimmeinheit, beispielsweise zum Führen eines kraftgeführten Roboters, als eine weitere Variante des Steuerrads aus FIGn. 5a und 5b. Die Ringform ermöglicht dem Nutzer stets eine ergonomische Haltung anzunehmen. Die ringförmige Zustimmeinheit besteht hierbei aus 16 ringförmig angeordneten zylindrischen Zustimmeinheiten 1030, ähnlich der in FIG. 8 gezeigten zylindrischen Zustimmeinheit 800. Jede der 16 zylinderförmigen Zustimmeinheiten beinhaltet zwei Sensorzellen, welche wiederum derart angeordnet sind, dass beide Zellen nur dann betätigt werden können, wenn die zylindrische Zustimmeinheit 1030 vollständig von einer Hand umfasst wird. Die ringförmige Zustimmeinheit ist über Streben 1020 mit einer Achse 1010 verbunden, auf der ein integrierter Sensorcontroller 1040 angeordnet ist. Dieser erfasst die Sensordaten von allen 16 zylindrischen Zustimmeinheiten 1030. Ein Freigabesignal wird nur dann generiert wenn, an mindestens 2 voneinander beabstandeten zylindrischen Zustimmeinheiten 1030 eine korrekte Betätigung erkannt wurde, das heißt, wenn an diesen zylindrischen Zustimmeinheiten 1030 auf beiden Sensorzellen eine Kraft innerhalb des vorgegebenen Freigabefensters gemessen wurde.

Weitere Ausführungsbeispiele ergeben sich für den Fachmann in naheliegender Art und Weise.

## Patentansprüche

1. Bedieneinheit zur Bedienung einer Maschine, wobei die Bedieneinheit mindestens eine Haltefläche und mindestens eine mit der Maschine verbindbare Signalverarbeitungseinrichtung umfasst, und die Signalverarbeitungseinrichtung konfiguriert ist mindestens ein Steuersignal an die Maschine zu übermitteln,
wobei
die Haltefläche mindestens ein erstes berührungssensitives Sensorsystem umfasst, und mindestens ein durch das erste berührungssensitive Sensorsystem ausgegebenes Signal in seiner Signalstärke von einer auf das erste berührungssensitive Sensorsystem aufgebrachten Kraft abhängig ist und das kraftabhängige Signal an die Signalverarbeitungseinrichtung übermittelt wird und die Signalverarbeitungseinrichtung derart konfiguriert ist, dass ein erstes Steuersignal durch ein beim Überschreiten einer ersten Kraft generiertes Signal und ein zweites Steuersignal durch ein beim Überschreiten einer zweiten Kraft generiertes Signal initiiert wird, wobei die zweite Kraft größer als die erste Kraft ist; und
das erste berührungssensitive Sensorsystem eine Vielzahl von Sensorzellen umfasst und derart konfiguriert ist, dass zumindest zwei verschiedenen Sensorzellen zugeordnete, durch das erste berührungssensitive Sensorsystem ausgegebene kraftabhängige Signale ortsauflösbar sind und die ausgegebenen kraftabhängigen Signale an die Signalverarbeitungseinrichtung übermittelt werden und das Steuersignal anhand der zwei, den verschiedenen Sensorzellen zugeordneten, Signale, und, wenn an beiden Sensorzellen eine Kraft erfasst ist, zusätzlich unter Berücksichtigung einer Gesamtsumme der auf die zwei Orte wirkenden Kräfte, initiiert wird.

2. Bedieneinheit nach Anspruch 1, wobei das berührungssensitive Sensorsystem auf piezoresistiven, kapazitiven, induktiven oder thermischen Messsystemen basiert, vorzugsweise ohne mechanische Schalt- und/oder Steuerelemente.

3. Bedieneinheit nach einem der vorhergehenden Ansprüche, wobei das berührungssensitive Sensorsystem ein flächiges Sensorsystem ist, so dass eine Berührung an mehr als einem Punkt der Haltefläche erfassbar ist.

4. Bedieneinheit nach einem der vorhergehenden Ansprüche , wobei die Signalverarbeitungseinrichtung derart ausgebildet ist, dass durch die auf das erste berührungssensitive Sensorsystem aufgebrachte Kraft ein Steuersignal generierbar ist, welches eine Steuergröße der Maschine in Abhängigkeit von der aufgebrachten Kraft, vorzugsweise kontinuierlich verändern kann.

5. Bedieneinheit nach einem der vorhergehenden Ansprüche, wobei das erste berührungssensitive Sensorsystem ein drucksensitives Sensorsystem ist.

6. Bedieneinheit nach einem der vorhergehenden Ansprüche, wobei das erste berührungssensitive Sensorsystem keine mechanischen Schalt- und/oder Steuerelemente umfasst.

7. Bedieneinheit nach einem der vorhergehenden Ansprüche, wobei die zwei verschiedenen Orte derart zueinander angeordnet sind, dass eine die Haltefläche berührende Hand beide Orte gleichzeitig berührt.

8. Bedieneinheit nach einem der vorhergehenden Ansprüche, wobei das erste berührungssensitive Sensorsystem mindestens einen Sensor mit einer Vielzahl von Sensorzellen oder eine Vielzahl von Sensoren aufweist, welche jeweils voneinander beabstandet sind.

9. Bedieneinheit nach einem der vorhergehenden Ansprüche, wobei die Bedieneinheit einen biegesteifen Grundkörper umfasst und die Haltefläche durch zumindest einen Teilabschnitt des biegesteifen Grundkörpers gegeben ist.

10. Bedieneinheit nach einem der vorhergehenden Ansprüche, wobei Ausgabeelemente vorhanden sind, welche zur Ausgabe eines Betriebszustands des Manipulators durch ein visuelles, auditorisches oder vibrotaktiles Ausgabesignal ausgebildet sind.

11. Bedieneinheit nach einem der vorhergehenden Ansprüche, wobei ein zweites berührungssensitives Sensorsystem vorhanden ist, wobei ein vom zweiten berührungssensitiven Sensorsystem ausgegebenes Signal unabhängig von einem durch das erste berührungssensitive Sensorsystem ausgegebenes Signal ist.

12. Bedieneinheit nach Anspruch 11, wobei das erste und der zweite berührungssensitive Sensorsystem zumindest abschnittsweise in Lagen übereinander auf der Haltefläche angeordnet sind.

13. Bedieneinheit nach einem der Ansprüche 11 oder 12, wobei das zweite berührungssensitive Sensorsystem auf piezoresistiven, kapazitiven, induktiven oder thermischen Messsystemen basiert, vorzugsweise ohne mechanische Schalt- und/oder Steuerelemente.

14. Bedieneinheit nach einem der Ansprüche 11 bis 13, wobei ein Signal des ersten berührungssensitiven Sensorsystems mit einem ersten Steuersignal korreliert ist und ein Signal des zweiten berührungssensitiven Sensorsystems mit einem zweiten Steuersignal korreliert ist.

15. Verwendung einer Bedieneinheit nach einem der vorhergehenden Ansprüche als Zustimmschalter für eine Maschine.

## Claims

1. An control unit for operating a machine, wherein the control unit comprises at least one retaining surface and at least one signal processing device that can be connected to the machine, and the signal processing device is configured to transmit at least one control signal to the machine,
wherein
the retaining surface comprises at least one first touch-sensitive sensor system, and at least one signal output by the first touch-sensitive sensor system depends for its signal strength on a force applied to the first touch-sensitive sensor system, and the force-dependent signal is transmitted to the signal processing device, and the signal processing device is configured such that a first control signal is initiated by a signal generated when a first force is exceeded and a second control signal is initiated by a signal generated when a second force is exceeded, wherein the second force is greater than the first force; and
the first touch-sensitive sensor system comprises a plurality of sensor cells and is configured such that at least two force-dependent signals assigned to different sensor cells and output by the first touch-sensitive sensor system can be spatially separable and the output force-dependent signals are transmitted to the signal processing device, and the control signal is initiated on the basis of the two signals assigned to the different sensor cells and, if a force is detected at both sensor cells, additionally taking into account a total sum of the forces acting on the two locations.

2. The ocontrol unit according to claim 1, wherein the touch-sensitive sensor system is based on piezoresistive, capacitive, inductive or thermal measuring systems, preferably without any mechanical switching and/or control elements.

3. The control unit according to any one of the preceding claims, wherein the touch-sensitive sensor system is a planar sensor system to enable the detection of a touch at more than one point on the retaining surface.

4. The ocontrol unit according to any one of the preceding claims, wherein the signal processing device is designed such that the force applied to the first touch-sensitive sensor system can generate a control signal which can change a control variable of the machine continuously, preferably in dependence on the applied force.

5. The control unit according to any one of the preceding claims, wherein the first touch-sensitive sensor system is a pressure-sensitive sensor system.

6. The control unit according to any one of the preceding claims, wherein the first touch-sensitive sensor system does not comprise any mechanical switching and/or control elements.

7. The control unit according to any one of the preceding claims, wherein the two different locations are arranged such that a hand touching the retaining surface touches both locations simultaneously.

8. The control unit according to any one of the preceding claims, wherein the first touch-sensitive sensor system comprises at least one sensor with a plurality of sensor cells or a plurality of sensors, each of which is spaced apart from the others.

9. The control unit according to any one of the preceding claims, wherein the control unit comprises a rigid base body and the retaining surface is provided by at least a partial section of the rigid base body.

10. The control unit according to any one of the preceding claims, wherein output elements are provided which are designed to output an operating state of the manipulator via a visual, auditory or vibrotactile output signal.

11. The ocontrol unit according to any one of the preceding claims, wherein a second touch-sensitive sensor system is provided, wherein a signal output by the second touch-sensitive sensor system is independent of a signal output by the first touch-sensitive sensor system.

12. The control unit according to claim 11, wherein the first and second touch-sensitive sensor systems are arranged at least partially in layers on top of each other on the retaining surface.

13. The control unit according to claim 11 or 12, wherein the second touch-sensitive sensor system is based on piezoresistive, capacitive, inductive or thermal measuring systems, preferably without any mechanical switching and/or control elements.

14. The control unit according to claims 11 to 13, wherein a signal from the first touch-sensitive sensor system is correlated with a first control signal and a signal from the second touch-sensitive sensor system is correlated with a second control signal.

15. Umethod of using an control unit according to any one of the preceding claims as an enabling switch for a machine.

## Revendications

1. Unité de commande pour la commande d'une machine, dans laquelle ladite unité de commande comprend au moins une surface de retenue et au moins un dispositif de traitement de signal pouvant être connecté à la machine, et ledit dispositif de traitement de signal est configuré pour transmettre au moins un signal de commande à la machine,
dans laquelle
la surface de retenue comprend au moins un premier système de capteur tactile, et la force de signal d'au moins un signal émis par ledit premier système de capteur tactile dépend d'une force appliquée sur ledit premier système de capteur tactile, et le signal dépendant de la force est transmis au dispositif de traitement de signal, et ledit dispositif de traitement de signal est configuré de telle manière qu'un premier signal de commande est déclenché par un signal généré lors du dépassement d'une première force, et qu'un second signal de commande est déclenché par un signal généré lors du dépassement d'une seconde force, ladite seconde force étant supérieure à la première force ; et
le premier système de capteur tactile comprend une pluralité de cellules de capteur et est configuré de telle manière que des signaux dépendants de la force et émis par le premier système de capteur tactile et associés à au moins deux cellules de capteur différentes peuvent être résolus spatialement, et que les signaux émis dépendants de la force sont transmis au dispositif de traitement de signal, et que le signal de commande est déclenché en se basant sur les deux signaux associés aux différentes cellules de capteur, et, si une force est détectée au niveau des deux cellules de capteur, en tenant compte en outre de la somme totale des forces agissant sur les deux emplacements.

2. Unité de commande selon la revendication 1, dans laquelle le système de capteur tactile est basé sur des systèmes de mesure piézorésistifs, capacitifs, inductifs ou thermiques, de manière préférée sans éléments de commutation et/ou de commande mécaniques.

3. Unité de commande selon l'une quelconque des revendications précédentes, dans laquelle le système de capteur tactile est un système de capteur planaire, de sorte qu'un contact peut être détecté au niveau de plus d'un point de la surface de retenue.

4. Unité de commande selon l'une quelconque des revendications précédentes, dans laquelle le dispositif de traitement de signal est conçu de telle manière qu'un signal de commande pouvant modifier, de manière préférée de manière continue, une grandeur de commande de la machine en fonction de la force appliquée peut être généré grâce à la force appliquée sur le premier système de capteur tactile.

5. Unité de commande selon l'une quelconque des revendications précédentes, dans laquelle le premier système de capteur tactile est un système de capteur sensible à la pression.

6. Unité de commande selon l'une quelconque des revendications précédentes, dans laquelle le premier système de capteur tactile ne comprend aucun élément de commutation et/ou de commande mécanique.

7. Unité de commande selon l'une quelconque des revendications précédentes, dans laquelle les deux emplacements différents sont agencés l'un par rapport à l'autre de telle manière qu'une main touchant la surface de retenue touche simultanément les deux emplacements.

8. Unité de commande selon l'une quelconque des revendications précédentes, dans laquelle le premier système de capteur tactile comprend au moins un capteur comprenant une pluralité de cellules de capteur ou une pluralité de capteurs qui sont respectivement espacé(e)s les un(e)s des autres.

9. Unité de commande selon l'une quelconque des revendications précédentes, dans laquelle l'unité de commande comprend un corps de base rigide et la surface de retenue est fournie grâce à au moins une sous-section du corps de base rigide.

10. Unité de commande selon l'une quelconque des revendications précédentes, dans laquelle des éléments de sortie sont présents afin d'indiquer l'état de fonctionnement du manipulateur grâce à un signal de sortie visuel, auditif ou vibrotactile.

11. Unité de commande selon l'une quelconque des revendications précédentes, dans laquelle un second système de capteur tactile est présent, un signal émis par le second système de capteur tactile étant indépendant d'un signal émis par le premier système de capteur tactile.

12. Unité de commande selon la revendication 11, dans laquelle les premier et second systèmes de capteur tactile sont agencés de manière superposée en couches au moins par sections sur la surface de retenue.

13. Unité de commande selon l'une quelconque des revendications 11 ou 12, dans laquelle le second système de capteur tactile est basé sur des systèmes de mesure piézorésistifs, capacitifs, inductifs ou thermiques, de manière préférée sans éléments de commutation et/ou de commande mécaniques.

14. Unité de commande selon l'une quelconque des revendications 11 à 13, dans laquelle un signal du premier système de capteur tactile est corrélé avec un premier signal de commande et un signal du second système de capteur tactile est corrélé avec un second signal de commande.

15. Utilisation d'une unité de commande selon l'une quelconque des revendications précédentes comme interrupteur d'activation pour une machine.
